# EUROPEAN PATENT APPLICATION

(11) **EP 1 168 427 A1**
(43) Date of publication of application: **02.01.2002**
(21) Application number: 01113400.4
(22) Date of filing: 01.06.2001
(51) Int. Cl.: H01L 21/318, H01J 37/32, C23C 16/34, C23C 16/507

(54) **Method of plasma depositing silicon nitride**

(30) Priority: 19.06.2000 US 596833
(71) Applicant: Applied Materials, Inc., Santa Clara, California 95054 (US)
(72) Inventor: Tan, Zhengquan, Cupertion, CA 95014 (US); Khazeni, Kasra, San Jose, CA 95118 (US)
(74) Representative: Kirschner, Klaus Dieter, Dipl.-Phys.

(57) **Abstract**

A method of forming silicon nitride having less 13 atomic percent hydrogen using an argon (Ar), nitrogen (N₂) and a silane (SiH₄) gas chemistry. In one embodiment, silicon nitride is deposited by forming a plasma from a gas mixture comprising about 100 to about 250 sccm of Ar, about 100 to about 500 sccm of N₂, and about 10 to about 80 sccm of SiH₄ in a plasma.

## Description

The present invention relates generally to a method of processing semiconductor wafers. More specifically, the invention relates to a method of depositing a layer of silicon nitride.

Integrated circuits have evolved into complex devices that can include millions of transistors, capacitors and resistors on a single chip. The evolution of chip designs continually requires faster circuitry and greater circuit density. As the circuit density decreases, the insulating performance of the dielectric layers becomes paramount.

One dielectric material that has been used is silicon nitride. Silicon nitride is generally used as an insulating dielectric material between adjacent layers or circuit structures. Silicon nitride is commonly formed using SiH₄, SiH₂Cl₂ and SiCl₄ in conjunction with NH₃ and N₂. During the silicon nitride deposition process, the hydrogen content of the film may vary with changes in the temperature, power density and frequency during the deposition processing cycle. Generally, the hydrogen content of the silicon nitride film is greater than 13 atomic percent. For example, plasma enhanced chemical vapor deposition of silicon nitride (deposited at about 400 degrees Celsius) typically contains about 25 atomic percent hydrogen. Increasing the temperature generally lowers the hydrogen content (*i.e.*, deposition at about 550 degrees Celsius lowers the hydrogen content to about 13 percent).

The silicon nitride film is typically used for an etch stop for intermetal dielectric (IMD) or premetal dielectric (PMD) layers. The etch selectivity with respect to the IMD or PMD layer is a critical performance parameter. A high etch selectivity is desirable. Another application of the silicon nitride is used as a copper barrier to prevent copper diffusion into the intermetal dielectric layer. Minimizing the penetration of copper into the silicon nitride layer is desirable to prevent electron migration and maintain the dielectric integrity of the silicon nitride film. Other properties desirable in silicon nitride films include low leakage current and high dielectric breakdown voltage.

The entrained hydrogen has a detrimental effect upon the dielectric performance of the silicon nitride layer in a number of ways. For example, the hydrogen bonds are often broken during subsequent processing, resulting in degradation of dielectric integrity, such as an increase in the leakage current and a decrease in dielectric breakdown voltage. The dielectric integrity may be degraded in more advanced semiconductor devices where the thickness of silicon nitride films used for copper barrier must be thin (typically 300-500Å). High hydrogen content in the nitride film additionally leads to lower etch selectivity with respect to silicon oxide.

Therefore, there is a need in the art for a silicon nitride deposition process and resulting film with improved dielectric properties.

One aspect of the invention provides a method for depositing silicon nitride having less than about 13 atomic percent hydrogen. In one embodiment, the invention provides a method of depositing silicon nitride in a plasma processing chamber from a plasma formed from a gas (or gas mixture) comprising argon (Ar), nitrogen (N₂) and silane (SiH₄).

The teachings of the present invention can be readily understood by considering the following detailed description in conjunction with the accompanying drawings, in which:
Fig. 1 depicts a schematic diagram of a plasma processing apparatus of the kind used in performing the deposition processes of the present invention;
Fig. 2 depicts a flow diagram of the inventive process; and,
Fig. 3 is a tabular summary of the processing parameters of the inventive method when practiced using the apparatus of Fig. 1.

To facilitate understanding, identical reference numerals have been used, where possible, to designate identical element that are common to the figures.

The present invention provides a method of forming silicon nitride having less than 13 atomic percent hydrogen. In one embodiment, the invention provides a method of depositing silicon nitride from a plasma formed from a gas (or gas mixture) comprising argon (Ar), nitrogen (N₂) and silane (SiH₄). The deposition process of the present invention can be performed in a plasma enhanced, chemical vapor deposition chamber, such as an Ultima® High Density Chemical Vapor Deposition (HDP-CVD) system, available from Applied Materials, Inc. of Santa Clara, California.

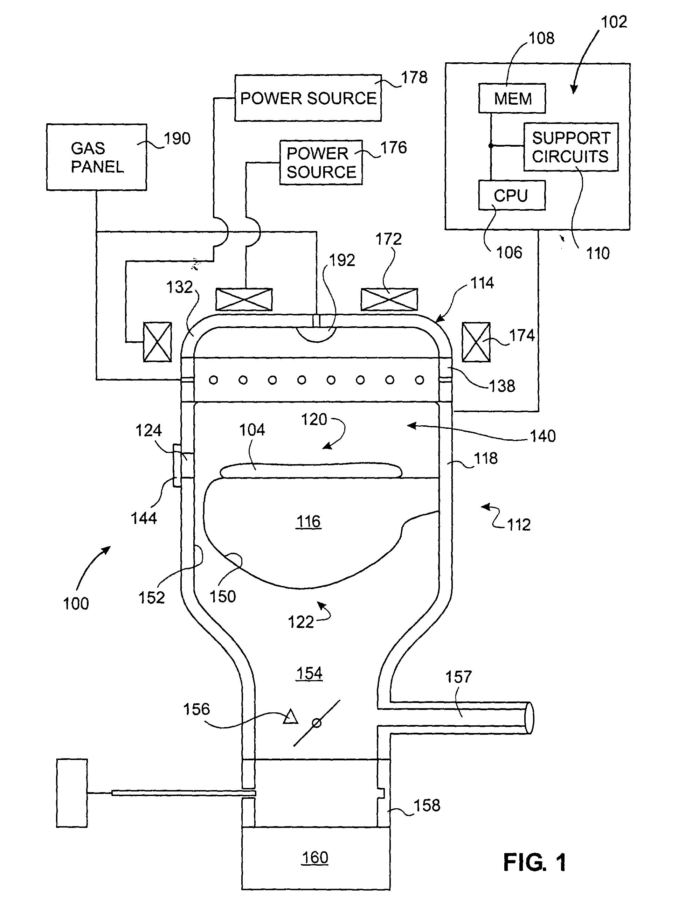

Fig. 1 depicts a HDP-CVD system (system) 100 in which the inventive deposition method may be practiced. The system 100 generally includes a chamber body 112, a lid assembly 114 and a substrate support member 116 which defines an evacuable enclosure (chamber) 140 for carrying out substrate processing. The system 100 is coupled to a controller 102 comprising a central processing unit (CPU) 106, a memory 108, and support circuits 110. The controller 102 is coupled to the various components of the HDP-CVD system 100 to facilitate control of the deposition process.

The chamber body 112 is preferably a unitary, machined structure having a sidewall 118 that defines an inner annular processing region 120 and tapers towards its lower end to define a concentric exhaust passage 122. The chamber body 112 defines a plurality of ports including at least a substrate entry port 124 that is selectively sealed by a slit valve 144.

The upper surface of the chamber wall 118 defines a generally flat landing area on which the lid assembly 114 is supported. One or more o-ring grooves are formed in the upper surface of the wall to receive one or more o-rings to form an airtight seal between the chamber body 112 and the lid assembly 114.

The chamber lid assembly 114 is generally comprised of an energy transmitting dome 132 and a gas distribution ring 138. The lid assembly 114 provides both the physical enclosure of the plasma processing region 120 as well as the energy delivery system to drive processing. The dome 132 is made of a dielectric material that is transmissive to RF energy, an example of which is a ceramic such as aluminum oxide (Al₂O₃). The temperature of the dome 132 is regulated during the various process cycles, i.e., deposition cycle and cleaning cycle. Typically, the dome 132 is heated during cleaning cycles and cooled during processing.

The gas distribution ring 138 is disposed between the dome 132 and the chamber body 112. O-ring grooves are formed in the top of the gas distribution ring 138 to receive an o-ring to seal the dome 132 and the top of the gas distribution ring 138. The gas distribution ring 138 typically comprises an annular ring made of aluminum or other suitable material having a plurality of ports formed therein for receiving nozzles and which are in communication a gas panel 190. The gas panel 190 may alternately be coupled to the chamber 140 via a showerhead 192. Optionally, both a showerhead 192 and gas distribution ring 138 may be used in conjunction with each other. The gas panel 190 provides process and other gases to the chamber 140.

Two separately powered RF coils, a top coil 172 and a side coil 174, are wound external to the dielectric dome 132. The RF coils 172 and 174 are powered by two variable frequency RF sources 176 and 178. Each power source (176 and 178) includes a control circuit and an RF matching network to transfer power to the plasma.

The substrate support member 116 is mounted to the chamber wall 118 to provide a generally annular substrate receiving surface in the center of the chamber 140. The substrate support member 116 also includes a temperature control system that maintains the temperature of a substrate 104 during processing. The controller 102 is coupled to the support member 116 and senses the temperature of the substrate 104. The controller 102 changes the temperature of the thermal fluid to maintain the substrate 104 at a predetermined temperature. Alternatively, other heating and cooling methods, such as resistive heating, may be utilized to control the temperature of the substrate 104 during processing.

When the support member 116 is positioned in the chamber 140, an outer wall 150 of the annular support member 116 and an inner wall 152 of the chamber 140 define the annular exhaust passage 122 that is substantially uniform about the entire circumference of the support member 116. The passage 122 terminates in an exhaust port 154 that is substantially concentric with the support member 116. The exhaust port 154 is disposed substantially centrally below the substrate receiving portion of the support member 116 to draw the gases evenly through the passage 122 and out of the chamber 140. This enables more uniform gas flow over the substrate surface about the entire circumference thereof and radially downwardly and outwardly from the chamber 140 through exhaust port 154 centered in the base of the chamber 140.

A pumping stack comprising a throttle assembly 156, a gate valve 158 and a turbomolecular pump 160 is mounted on the tapered lower portion of the chamber body 112 to provide pressure control within the system 100. The throttle assembly 156 and the gate valve 158 are mounted between the chamber body 112 and the turbomolecular pump 160 to allow isolation via gate valve 158 and/or pressure control at pressures. A foreline 157 is connected to the exhaust port 154 at a position upstream and downstream from the turbomolecular pump 160. This provides backing pump capability. The foreline 157 is connected to the remote mainframe pump (not shown), typically a roughing pump.

During processing of the substrate 104 in the chamber 140, the vacuum pump evacuates the chamber 140 to a pressure in the range of about 2 to about 15 mTorr, and a metered flow of a process gas or gases is supplied through the gas distribution assembly and into the chamber 140. The chamber pressure is controlled by directly measuring the chamber pressure and feeding this information to the controller that opens and closes the valves to adjust pumping speed. Gas flows and concentrations are controlled directly by mass flow controllers through a software set point provided in a process recipe. By measuring the flow rate of gases being pumped out of the chamber 140 through the exhaust port 154, a mass flow controller (not shown) on the inlet gas supply can also be used to maintain the desired pressure and gas concentration in the chamber 140.

In operation, the semiconductor substrate 104 depicted in Fig. 1 is placed on the substrate support member 116 and gaseous components are supplied from a gas panel to the process chamber through entry ports 124 to form a gaseous mixture. The gaseous mixture is ignited into a plasma in the process region 120 by applying RF power from the RF sources and respectively to the top coil 172, the side coil 174, and the substrate support member 116. Alternately, the gaseous mixture may ignited by other methods. The pressure within the interior of the chamber 140 is controlled using the throttle valve situated between the chamber 140 and the vacuum pump. The temperature at the surface of the chamber walls is controlled using liquid-containing conduits (not shown) that are located in the walls of the system 100.

The temperature of the substrate 104 is controlled by stabilizing the temperature of the support member 116 and flowing helium gas from a source (not shown) to the channels formed by the back of the substrate and grooves (not shown) on the substrate support surface. The helium gas is used to facilitate heat transfer between the substrate 104 and the substrate support member 116. During the deposition process, the substrate 104 is heated to a steady state temperature. Using thermal control of both the dome 132 and the substrate support member 116, the substrate 104 is maintained at a temperature of 250 to 500 degrees Celsius.

The RF power applied to the top inductive coil 172 has a frequency between 50 kHz and 13.56 MHz and may vary in power from a few hundred Watts to several thousand Watts. The RF power applied to the side inductive coil 174 has a frequency between 50 kHz and 13.56 MHz and may vary in power from a few hundred Watts to several thousand Watts. The power applied to the substrate support member 116 may be DC or RF, and is generally used to improve step coverage. As little as no bias power may be used. In one embodiment of the invention, the top coil power has a frequency of 12.56 MHz and a power of between about 1000 and about 4800 Watts, and the side coil power has a frequency of 12.56 MHz and a power of between about 1000 and about 4800 Watts, while the bias power has a frequency of 13.56 MHz with a power of up to about 5000 Watts.

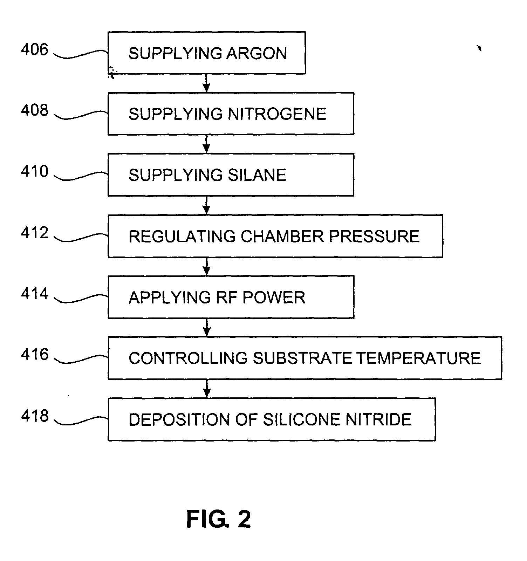

To facilitate control of the system 100 as described above, the CPU 106 may be one of any form of general purpose computer processor that can be used in an industrial setting for controlling various chambers and subprocessors. The memory 108 is coupled to the CPU 106. The memory 108, or computer-readable medium, may be one or more of readily available memory such as random access memory (RAM), read only memory (ROM), floppy disk, hard disk, or any other form of digital storage, local or remote. The support circuits 110 are coupled to the CPU 106 for supporting the processor in a conventional manner. These circuits include cache, power supplies, clock circuits, input/output circuitry and subsystems, and the like. A deposition process 400 of the present invention is typically implemented by the CPU 106 and is generally stored in the memory 108 as part of a software routine 402. The software routine 402 is discussed below with respect to Fig. 2. The software routine 402 may also be stored and/or executed by a second CPU (not shown) that is remotely located from the hardware being controlled by the CPU 106.

The deposition process 400 is depicted in greater detail in Fig. 2. The deposition process 400 comprises the steps of supplying argon to the system 100 (step 406), supplying nitrogen to the system 100 (step 408), supplying silane to the system 100 (step 410), regulating the pressure of the argon, nitrogen and silane within system 100 (step 412), applying RF power to the system 100 to form and sustain a plasma 152 (step 414), controlling the wafer temperature (step 416), and depositing silicon nitride (step 418). In one embodiment, no basis power is utilized during deposition.

Referring simultaneously to Fig. 1 and Fig. 2, the software routine 402 when executed by the CPU 106, transforms the general purpose computer into the specific purpose computer (controller) 102 that controls the chamber operation such that the deposition process is performed. Although the process of the present invention is discussed as being implemented as a software routine, some of the method steps that are disclosed therein may be performed in hardware as well as by the software controller. As such, the invention may be implemented in software as executed upon a computer system, in hardware as an application specific integrated circuit or other type of hardware implementation, or a combination of software and hardware.

More specifically, silicon nitride is deposited on the wafer 104, for example, by first supplying the gaseous mixture comprising about 200 sccm of argon, about 200 sccm of nitrogen and about 20 sccm of silane, to the chamber in steps 406, 408 and 410, respectively. In step 412, the total pressure of the gas mixture in the system 100 is regulated to about 6 mTorr.

Once the gas mixture is present above the wafer 104, step 414 applies about 1500 Watts of RF power to the top coil, and applies about 3000 Watts of RF power to the side coil, forming and sustaining the plasma. The wafer 104 heated to about 400 degrees Celsius in step 416. Deposition of the silicon nitride having a hydrogen content of less than or equal to about 8 atomic percent upon the wafer 104 occurs in step 418.

The hydrogen content of the silicon nitride layer obtained by the process 400 compares advantageously with silicon nitride deposited using prior art techniques. A comparison between silicon nitride films illustrates that films deposited utilizing the process 400 exhibit favorable physical properties as compared with films deposed through prior art techniques. For example, the silicon nitride film of process 400 typically has a wet etch rate of 6.5 Å/min in 6:1 BOE (buffered oxide etcher) solution and a hydrogen content of about 8 atomic percent (measured by hydrogen forward scattering technique). The plasma enhanced chemical vapor deposition films of the prior art generally have a wet etch rate of 65 Å/min in 6:1 BOE and a hydrogen content of about 14 atomic percent.

Additionally, the silicon nitride film of process 400 has superior barrier properties as compared to silicon nitride films deposited utilizing techniques known in the art. The copper diffusion length, or depth to which copper penetrates into the silicon nitride film to a concentration of 10⁻⁴ atomic percent, is substantially improved when the process 400 is utilized. Diffusion lengths for plasma enhanced chemical vapor deposition films of the prior art are generally about 300 Å. Diffusion lengths for films deposited using process 400 are generally about 150 Å. Films that have short diffusion lengths may be used to advantage in integrated circuit structures fabricated from thin films to minimize electron migration.

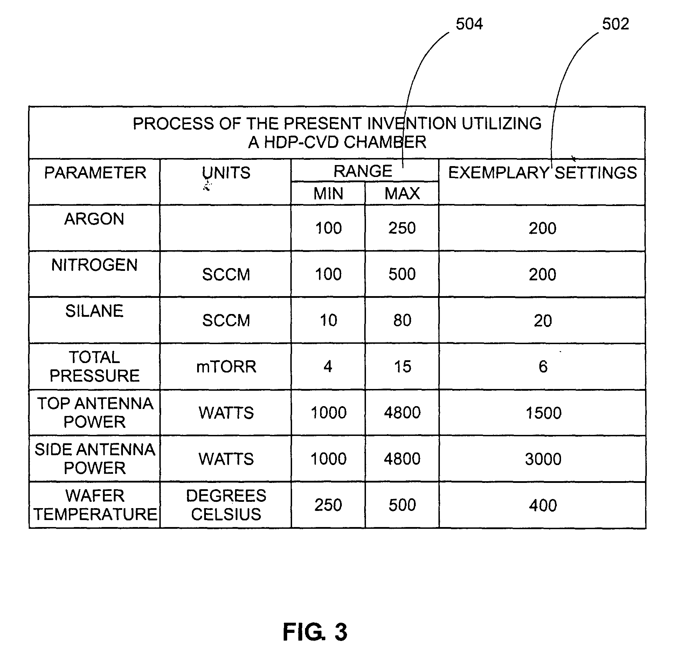

The deposition process parameters for the embodiment of the invention disclosed above are summarized in column 502 of Fig. 3. Column 504 of Fig. 3 includes the process ranges through which one can practice the invention using a Ultima® HDP-CVD system.

Additionally, the invention may be practiced in other deposition equipment wherein the processing parameters may be adjusted to achieve acceptable etch selectivity and copper barrier characteristics by those skilled in the arts by utilizing the teachings disclosed herein without departing from the spirit of the invention.

## Claims

1. A method of forming silicon nitride in a plasma processing chamber comprising the step of combining argon (Ar), nitrogen (N₂), and silane (SiH₄) in a plasma.

2. The method of claim 1 wherein said combining step further comprises the step of supplying 100 to 250 sccm of Ar, preferably supplying 200 sccm of Ar.

3. The method of claim 1 wherein said combining step further comprises the step of supplying 100 to 500 sccm of N₂, preferably 200 sccm of N₂.

4. The method of claim 1 wherein said combining step further comprises the step of supplying 10 to 80 sccm of SiH₄, preferably 20 sccm of SiH₄.

5. The method of claim 1 wherein said combining step further comprises the step of maintaining a total gas pressure of between 2 to 15 mTorr, preferably a total gas pressure of 6 mTorr.

6. The method of claim 1 further comprising the step of maintaining the workpiece at 250 to 500 °C, preferably at 400 °C.

7. The method of claim 1 further comprising the step of applying an inductive source power to a first inductively coupled coil of 1000 to 4800 Watts, preferably of 1500 Watts.

8. The method of claim 1 further wherein the formed silicon nitride comprises less than 13 atom percent hydrogen.

9. The method of claim 1 further comprising the step of applying an inductive source power to a second inductively coupled coil of 1000 to 4800 Watts, preferably of 3000 Watts.

10. A computer-readable medium having stored thereon a plurality of instructions, the plurality of instructions including instructions which, when executed by a processor, cause the processor to control a semiconductor wafer processing chamber to perform the method of any of the proceeding claims for combining argon (Ar), nitrogen (N₂), and silane (SiH₄) in a plasma, wherein the combining step result in the formation of silicon nitride having less than 13 atomic percent hydrogen.

11. A silicon nitride having less than 13 atomic percent hydrogen film formed in a chemical vapor deposition chamber by the process of combining argon (Ar), nitrogen (N₂), and silane (SiH₄) in a plasma.
